# FASCICULE DE BREVET EUROPEEN

(11) **EP 0 722 092 B1**
(45) Date de publication et mention de la délivrance du brevet: **03.03.2004**
(21) Numéro de dépôt: 95410146.5
(22) Date de dépôt: 22.12.1995
(51) Int. Cl.: G01R 31/327

(54) **Dispositif d'essai d'un relais de protection connecté à des capteurs de courant amagnétiques**
Testanordnung für ein mit amagnetischen Stromfühlern verbundenes Sicherheitsrelais
Test appliance for protection relays linked to amagnetic current sensors

(30) Priorité: 16.01.1995 FR 9500484
(43) Date de publication de la demande: 17.07.1996
(73) Titulaire: Schneider Electric Industries SAS, 92500 Rueil-Malmaison (FR)
(72) Inventeur: Souchère, Claude, F-38050 Grenoble Cedex 09 (FR)
(74) Mandataire: Jouvray, Marie-Andrée

(56) Documents cités:
- EP-A- 0 337 235
- EP-A- 0 452 228

## Description

L'invention concerne un dispositif d'essai d'un relais de protection ayant une entrée connectée à des capteurs de courant, dispositif comportant un générateur de courant fournissant un courant d'essai de valeur prédéterminée, et des moyens de connexion pour connecter la sortie du dispositif d'essai en parallèle sur l'entrée du relais.

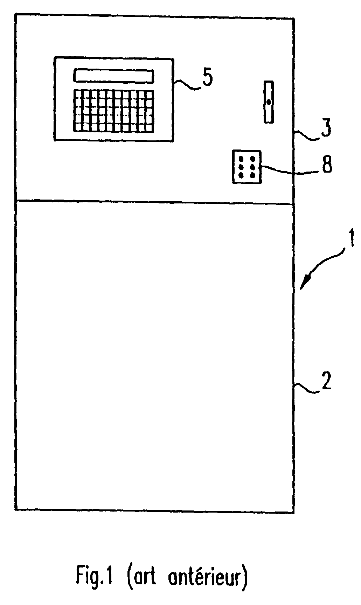

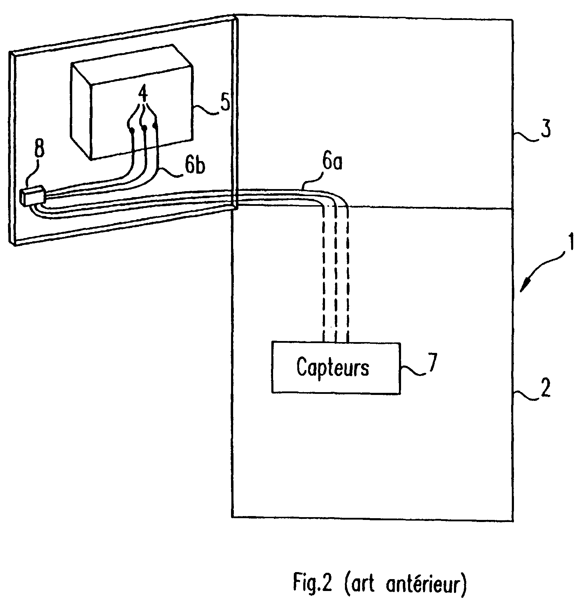

Un tel dispositif est plus particulièrement destiné au test d'un relais de protection moyenne tension. Comme représenté aux figures 1 et 2, une cellule moyenne tension 1 comporte classiquement un caisson disjoncteur 2 et un caisson basse-tension 3. L'entrée 4 d'un relais de protection 5, disposé dans le caisson basse-tension 3, est connectée par des conducteurs de liaison 6, à des capteurs de courant 7 disposés dans le caisson disjoncteur 2. Les capteurs de courant 7 sont généralement des capteurs magnétiques, par exemple sous forme de tores, standardisés pour fournir dans des enroulements secondaires des courant nominaux de 1A ou de 5A. Dans les cellules classiques équipées de capteurs magnétiques, une boîte à bornes 8, accessible par l'utilisateur, disposée sur la face avant du caisson basse-tension 3, est interposée entre les capteurs 7 et le relais de protection. Les conducteurs de liaison 6 sont sous-divisés en conducteurs 6a reliant les capteurs 7 à la boîte 8 et en conducteurs 6b reliant la boîte 8 à l'entrée 4 du relais 5. En fonctionnement normal de la cellule 1, la boîte 8 assure la connexion des conducteurs 6a et 6b et, en conséquence, la connexion des capteurs 7 et du relais de protection 5. Pour tester le relais de protection 5, un générateur de courant 9 est connecté à des entrées externes (voir fig. 1) de la boîte à bornes 8. Cette connexion provoque la mise en court-circuit des enroulements secondaires des capteurs 7, l'ouverture de la liaison (6a-6b) capteurs-relais de protection et la connexion de la sortie du générateur 9 à l'entrée 4 du relais 5, par l'intermédiaire des conducteurs 6b. Il est ainsi possible d'appliquer à l'entrée 4 du relais de protection 5 un courant d'essai de valeur prédéterminée et de vérifier le fonctionnement du relais de protection 5. De manière classique, le courant d'essai fourni par le générateur est de l'ordre de 50 A pour un courant nominal de 5 A au secondaire des capteurs, permettant une vérification du relais de protection pour un courant de l'ordre de 10 fois le courant nominal du réseau électrique à protéger.

Les relais de protection moyenne tension connus peuvent également être associés à des capteurs de courant amagnétiques. Cependant, le dispositif d'essai classique, constitué par le générateur de courant 9 et la boîte à bornes 8, n'est pas adapté à ce type de capteurs. En effet, les capteurs amagnétiques fournissent des tensions, généralement de l'ordre de 40 mV, comme signaux représentatifs du courant à mesurer. Les signaux d'essai fournis à l'entrée 4 du relais ne peuvent donc être les signaux de sortie du générateur de courant 9.

De plus, la puissance fournie par un capteur amagnétique est très faible, le courant délivré étant de l'ordre du microampère. Par ailleurs, l'interruption de la liaison capteurs-relais de protection par une boîte à bornes classique introduit des résistances parasites qui ne peuvent être négligées et qui altèrent de façon inacceptable la précision du dispositif d'essai. La connexion d'un générateur de tension d'essai adapté sur la boîte à bornes classique n'est donc pas une solution satisfaisante.

La demande de brevet EP 0 337 235 divulgue un dispositif d'essai de relais de protection selon le préambule de la revendication 1.

L'invention a pour but un dispositif d'essai adapté aux capteurs amagnétiques.

Selon l'invention ce but est atteint par les caractéristiques de la revendication 1.

Les signaux d'essai sont ainsi injectés en parallèle sur les signaux de mesure fournis par les capteurs et il est possible de tester un relais de protection, connecté à des capteurs amagnétiques, en utilisant un générateur de courant classique, normalement utilisé pour tester les relais à capteurs magnétiques.

Les moyens de connexion de la sortie de l'interface à l'entrée du relais de protection peuvent comporter une entrée-test spécifique disposée sur le relais et connectée à ladite entrée du relais.

Selon un développement de l'invention, le relais de protection est un relais standard ne comportant pas d'entrée test spécifique. Un tel relais est destiné à être connecté directement à des capteurs amagnétiques qui fournissent des signaux dont le niveau est compatible avec le circuit de traitement du relais. Le brevet français 2.688.099 décrit un bloc de connexion permettant à un tel relais standard d'être également connecté à des capteurs magnétiques. Ce bloc de connexion, interposé sur le trajet des conducteurs 6b, entre la boîtes à bornes 8 et l'entrée 4 du relais 5, transforme les signaux de sortie de capteurs magnétiques, ou du générateur de courant 9 connecté à la boîte à bornes 8, en signaux de tension compatibles avec le circuit de traitement du relais. Dans le cas où le relais standard est connecté à des capteurs amagnétiques, les moyens de connexion de l'interface à l'entrée du relais comportent alors, de préférence, des connecteurs en forme de té ayant une première entrée connectée à des premiers conducteurs de liaison connectés aux capteurs, une sortie connectée à des seconds conducteurs de liaison connectés à l'entrée du relais de protection, et une seconde entrée destinée à être connectée à l'interface en période d'essai du relais de protection.

Selon un mode de réalisation préférentiel, les connecteurs en forme de té sont disposés à l'emplacement d'une boîte à bornes d'une cellule comportant le relais de protection, la seconde entrée des connecteurs étant accessible par un utilisateur sur la face avant de la cellule.

D'autres avantages et caractéristiques ressortiront plus clairement de la description qui va suivre de modes particuliers de réalisation de l'invention, donnés à titre non limitatif et représentés aux dessins annexés, dans lesquels :
Les figures 1 et 2 représentent une cellule moyenne tension de type classique, dont le caisson basse tension est respectivement fermé et ouvert.
La figure 3 représente un premier mode de réalisation d'un dispositif d'essai selon l'invention.
La figure 4 représente un schéma électrique équivalent du système selon la figure 3.
La figure 5 représente, plus en détail, un mode particulier de réalisation de l'interface selon la figure 3.
La figure 6 représente un second mode de réalisation de l'invention.
La figure 7 représente un mode particulier de réalisation d'un connecteur en forme de té du dispositif selon la figure 6.

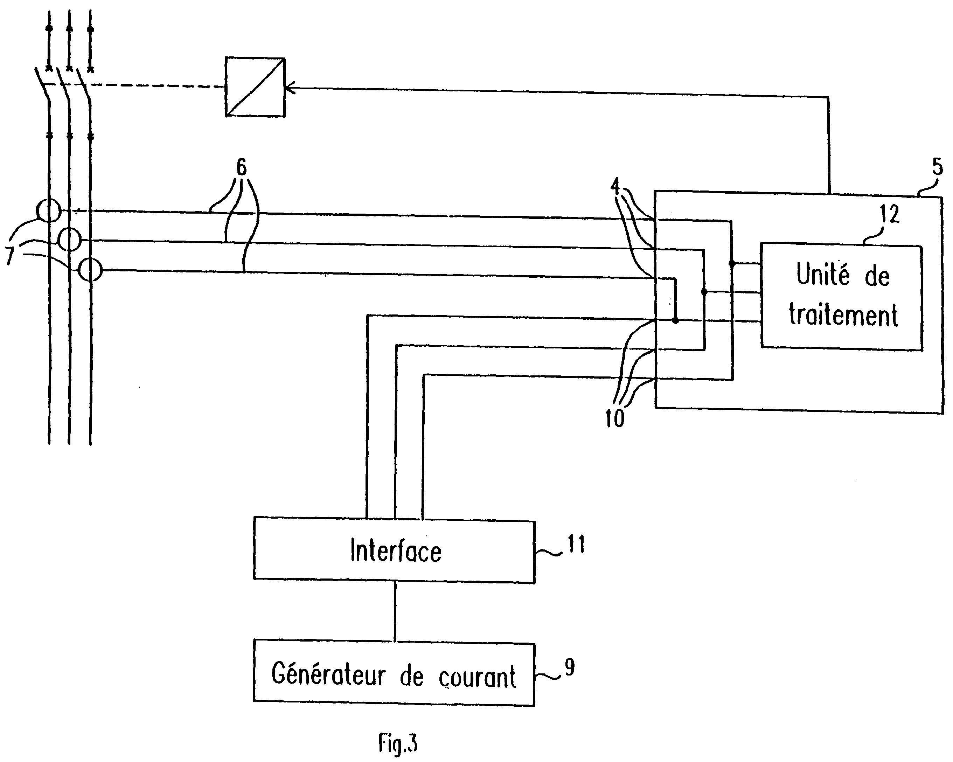

Sur la figure 3, l'entrée 4 du relais de protection 5 est connectée par les conducteurs de liaison 6 à des capteurs amagnétiques 7 mesurant le courant circulant dans chacun des conducteurs d'un réseau électrique triphasé. Le relais 5 comporte, de plus, une entrée-test 10, spécifique, connectée directement, comme l'entrée 4 du relais 5, à l'entrée d'une unité de traitement 12. Le dispositif de test comporte un générateur de courant 9, du type classiquement utilisé pour le test d'un relais à capteurs magnétiques. Une interface 11 est connectée, par des liaisons coaxiales, entre le générateur de courant 9 et l'entrée-test 10.

Ainsi, les signaux de sortie de l'interface 11 sont appliqués directement à l'entrée de l'unité de traitement 12 qui les traite de la même manière que des signaux en provenance des capteurs 7 qui lui sont appliqués en parallèle.

L'interface 11 est une interface à basse impédance de sortie, de manière à ce que, pendant un essai, l'unité de traitement de tension 12 du relais 5 prenne en compte les signaux de tension fournis par le dispositif d'essai et non les signaux de tension qui lui sont fournis par les capteurs 6.

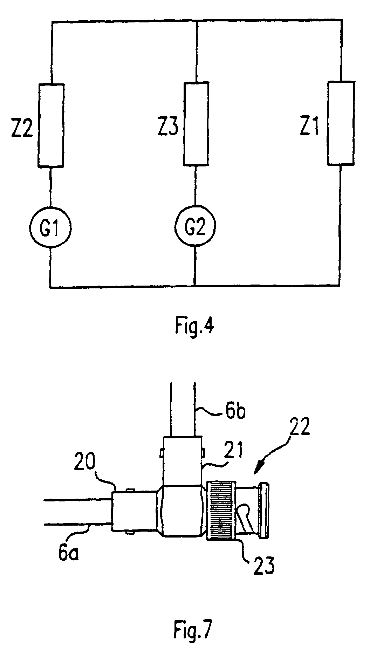

Sur le schéma électrique équivalent représenté à la figure 4, l'impédance d'entrée Z1 de l'unité de traitement 12 du relais est de l'ordre de la dizaine de kiloohms. L'impédance Z2 des capteurs amagnétiques, disposée en série avec un générateur de tension G1 aux bornes de l'impédance Z1, est généralement de l'ordre de quelques centaines d'ohms, par exemple 300 ohms. L'interface 11 peut être représentée par un circuit série, constitué par un générateur G2 et une impédance Z3, disposé en parallèle sur l'impédance Z1. Les générateurs G1 et G2 fournissent tous deux des tensions de l'ordre de quelques dizaines de millivolts, typiquement 40 mV, adaptées au niveau d'entrée de l'unité de traitement. Pour que les signaux d'essai ne soient pas perturbés par les signaux en provenance des capteurs, l'interface 11 est conçue de manière à avoir une impédance Z3 très inférieure à l'impédance des capteurs. En pratique Z3 est de l'ordre de quelques ohms, par exemple 3 ohms. Ainsi, l'erreur en phase et en module des signaux d'essai vus par l'unité de traitement en cours d'essai est négligeable. De plus dès que l'injection de signaux d'essai est interrompue, l'unité de traitement traite les signaux de mesure fournis par les capteurs 7.

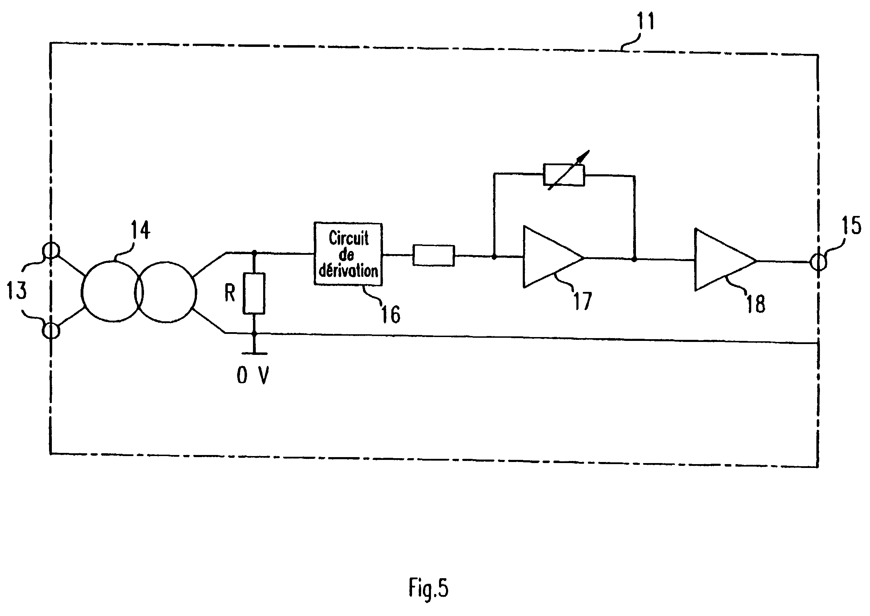

Sur la figure 5, un mode de réalisation particulier de l'interface 11 comporte, pour chaque phase, une entrée 13 destinée à être connectée au générateur de courant 9. L'entrée 13 est connectée à l'enroulement primaire d'un transformateur 14. Une résistance R est connectée aux bornes d'un enroulement secondaire du transformateur 14. Les signaux de courant fournis par le générateur d'essai 9 sont ainsi transformés en signaux de tension. Les signaux de tension ainsi obtenus sont appliqués entre la masse et une sortie 14 de l'interface 11 par l'intermédiaire d'un circuit de dérivation 16 connecté en série avec un amplificateur à gain variable 17 et un amplificateur 18 à faible impédance de sortie. Ces différents circuits, de type connu, peuvent être réalisés par tout moyen approprié et ne seront pas décrits plus en détail.

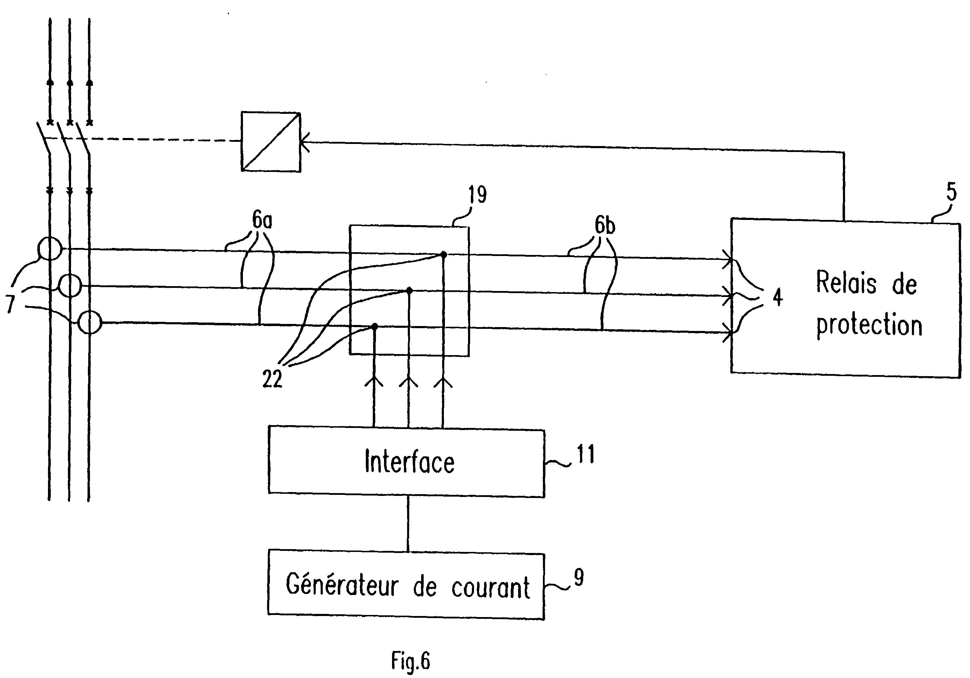

Dans le mode de réalisation de la figure 3, le relais de protection 5 comporte une entrée-test 10 spécifique. Une telle entrée n'est pas prévue dans les disjoncteurs existants. Le mode de réalisation représenté aux figures 6 et 7 comporte des moyens de connexion 19 permettant de brancher la sortie de l'interface 11 en parallèle sur les conducteurs 6 sans interrompre ceux-ci. Les conducteurs 6a et 6b de chaque phase sont connectés respectivement à une première entrée 20 et à une sortie 21 d'un connecteur associé 22 en forme de té. Une seconde entrée 23 du connecteur 22 est destinée à être connectée à une sortie de l'interface 11.

Selon un mode de réalisation préférentiel, les connexions 22 en forme de té sont disposées à l'emplacement de la boîte à bornes 8 dans la cellule 1 de manière à ce que leurs secondes entrées 23 soient accessibles par l'utilisateur depuis la face avant de la cellule.

Il est ainsi possible d'utiliser un relais de protection 5 standard et de le personnaliser lors de son montage dans la cellule 1. Le relais est alors connecté soit à des capteurs magnétiques par l'intermédiaire d'une boîte à bornes classiques 8, soit à des capteurs magnétiques par l'intermédiaire de connecteurs en té 23, disposés à l'emplacement de la boîte à bornes 8. Dans le premier cas, un générateur de courant 9 classique est connecté à l'entrée de la boîtes à bornes pour tester le relais. Dans le second cas, le générateur 9 est connecté aux secondes entrées 23 des connecteurs en té 22 par l'intermédiaire de l'interface 11. Pour éviter toute erreur lors des essais, un connecteur de sortie du générateur est complémentaire d'un connecteur d'entrée de la boîte à bornes classique et de l'interface mais la disposition spatiale des entrées des connecteurs en té est telle qu'une connexion directe du connecteur de sortie du générateur 9 n'est pas possible. Cette disposition spatiale est par contre telle qu'elle est complémentaire d'un connecteur de sortie de l'interface 11.

Les figures 3 et 6 représentent respectivement la connexion de la sortie de l'interface 11 directement sur le relais 5 et sur les conducteurs 6. Il est également possible de prévoir une telle connexion directement sur le secondaire des capteurs amagnétiques 7.

Les boîtes à bornes classiques comportent parfois une prise supplémentaire permettant de connecter un enregistreur en série avec les capteurs pour enregistrer le courant d'entrée du relais. Dans le dispositif décrit ci-dessus, la seconde entrée (23) des connecteurs en té (22) peut être utilisée pour le branchement d'un enregistreur destiné à enregistrer la tension de sortie des capteurs. Un tel enregistreur doit avoir une impédance élevée, par comparaison à l'impédance Z2 des capteurs, pour ne pas perturber la mesure.

Le dispositif d'essai selon l'invention a été décrit dans son application préférentielle à un relais de protection moyenne tension, mais il n'est pas limité à cette gamme de tension.

## Revendications

1. Dispositif d'essai d'un relais de protection (5), ledit relais ayant une entrée (4) connectée à des capteurs de courant (7), le dispositif comportant un générateur de courant (9) fournissant un courant d'essai de valeur prédéterminée, et des moyens de connexion pour connecter la sortie du dispositif d'essai en parallèle sur l'entrée du relais, dispositif **caractérisé en ce que**, les capteurs de courant étant des capteurs de courant amagnétiques, il comporte une interface (11), connectée au générateur de courant (9) et comportant des moyens (14, R) de transformation de signaux de courant en signaux de tension et des moyens de mise en forme (16, 17 18) connectés aux moyens de transformation (14, R) d'une part et à une sortie (15) de l'interface d'autre part et ayant une impédance de sortie (Z3) de l'ordre de quelques ohms, très basse par comparaison avec l'impédance (Z2) de sortie des capteurs de courant (7), et les moyens de connexion (19) connectant la sortie (15) de l'interface en parallèle sur l'entrée (4) du relais de protection (5).

2. Dispositif selon la revendication 1, **caractérisé en ce que** les moyens de connexion (19) comportent des connecteurs (22) en forme de té ayant une première entrée (20) pouvant être connectée à des premiers conducteurs de liaison (6a) connectés aux capteurs de courant (7), une sortie (21) connectée à des seconds conducteurs de liaison (6b) pouvant être connectés à l'entrée (4) du relais de protection (5), et une seconde entrée (23) connectée à l'interface (11) en période d'essai du relais de protection (5).

3. Dispositif selon la revendication 2, **caractérisé en ce que** les connecteurs (22) en forme de té sont disposés à l'emplacement d'une boîte à bornes (8) d'une cellule (1) comportant le relais de protection (5), la seconde entrée (23) des connecteurs étant accessible par un utilisateur sur la face avant de la cellule (1).

4. Dispositif selon la revendication 1, **caractérisé en ce que** les moyens de connexion comportent une entrée-test (10) spécifique du relais de protection (5) disposée sur le relais de protection et pouvant être connectée à ladite entrée (4) du relais de protection.

## Claims

1. A device for testing a protection relay (5), said relay having an input (4) connected to current sensors (7), the device comprising a current generator (9) supplying a test current of preset value, and connecting means to connect the output of the test device in parallel to the input of the relay, device **characterized in that** the current sensors being non-magnetic current sensors, it comprises an interface (11) connected to the current generator (9) and comprising transformation means (14, R) for transforming current signals into voltage signals and shaping means (16, 17, 18) connected to the transformation means (14, R) on the one hand and to an output (15) of the interface on the other hand and having an output impedance (Z3) of about a few ohms, very low in comparison with the output impedance (Z2) of the current sensors (7) and the connection means (19) connecting the output (15) of the interface in parallel to the input (4) of the relay (5).

2. Device according to claim 1, **characterized in that** the connecting means (19) comprise T-shaped connectors (22) having a first input (20) able to be connected to first connecting conductors (6a) connected to the current sensors (7), an output (21) connected to second connecting conductors (6b) able to be connected to the input (4) of the protection relay (5), and a second input (23) connected to the interface (11) during the testing period of the protection relay (5).

3. Device according to claim 2, **characterized in that** the T-shaped connectors (22) are arranged at the location of a terminal box (8) of a cubicle (1) comprising the protection relay (5), the second input (23) of the connectors being accessible by a user on the front panel of the cubicle (1).

4. Device according to claim 1, **characterized in that** the connecting means (22) comprise a specific test input (10) of the protection relay (5) arranged on the protection relay and able to be connected to said input (4) of the protection relay.

## Patentansprüche

1. Prüfanordnung eines Schutzrelais (5), welches Relais einen mit Stromwandlern (7) verbundenen Eingang (4) umfaßt, wobei die Anordnung eine Stromquelle (9), die einen Prüfstrom eines bestimmten Wertes liefert, sowie Verbindungsmittel umfaßt, die dazu dienen, den Ausgang der Prüfanordnung parallel auf den Eingang des Relais zu schalten, **dadurch gekennzeichnet, daß** die Anordnung bei Auslegung der Stromwandler als nichtmagnetische Stromwandler eine Schnittstelle (11) umfaßt, die mit der Stromquelle (9) verbunden ist und Mittel (14, R) zur Umwandlung von Stromsignalen in Spannungssignale sowie Formungsmittel (16, 17, 18) umfaßt, die einerseits an die Umwandlungsmittel (14, R) und andererseits an einen Ausgang (15) der Schnittstelle angeschlossen sind und eine im Vergleich zur Ausgangsimpedanz (Z2) der Stromwandler (7) sehr niedrige Ausgangsimpedanz (Z3) im Bereich von einigen Ohm aufweisen, und die Verbindungsmittel (19) den Ausgang (15) der Schnittstelle parallel auf den Eingang (4) des Schutzrelais (5) schalten.

2. Anordnung nach Anspruch 1, **dadurch gekennzeichnet, daß** die Verbindungsmittel (19) T-förmige Verbinder (22) umfassen, die einen ersten Eingang (20), der mit an die Stromwandler (7) angeschlossenen ersten Verbindungsleitern (6a) verbunden werden kann, einen Ausgang (21), der mit zweiten Verbindungsleitern (6b) verbunden ist, die an den Eingang (4) des Schutzrelais (5) angeschlossenen werden können, sowie einen zweiten Eingang (23) aufweisen, der während des Prüfvorgangs des Schutzrelais (5) mit der Schnittstelle (11) verbunden wird.

3. Anordnung nach Anspruch 2, **dadurch gekennzeichnet, daß** die T-förmigen Verbinder (22) alternativ an der Einbaustelle eines Klemmenkastens (8) einer das Schutzrelais (5) enthaltenden Schaltzelle (1) montiert sind, wobei der zweite Eingang (23) der Verbinder für einen Anwender von der Vorderseite der Schaltzelle (1) her zugänglich ist.

4. Anordnung nach Anspruch 1, **dadurch gekennzeichnet, daß** die Verbindungsmittel einen spezifischen Prüfeingang (10) des Schutzrelais (5) umfassen, der am Schutzrelais angeordnet ist und mit dem genannten Eingang (4) des Schutzrelais verbunden werden kann.
